Europäisches Patentamt

European Patent Office

Office européen des brevets

(19)

(11) Numéro de publication: **0 251 386**
**A1**

(12) **DEMANDE DE BREVET EUROPEEN**

(21) Numéro de dépôt: **87201159.8**

(22) Date de dépôt: **17.06.87**

(51) Int. Cl.4: **H01L 27/14** , H01L 29/78

(30) Priorité: **24.06.86 FR 8609087**
**18.02.87 FR 8702070**

(43) Date de publication de la demande:
**07.01.88 Bulletin 88/01**

(84) Etats contractants désignés:
**DE FR GB IT NL SE**

(71) Demandeur: **Laboratoires d'Electronique et de Physique Appliquée L.E.P.**
**3, Avenue Descartes**
**F-94450 Limeil-Brévannes(FR)**

(84) **FR**

(71) Demandeur: **N.V. Philips' Gloeilampenfabrieken**
**Groenewoudseweg 1**
**NL-5621 BA Eindhoven(NL)**

(84) **DE GB IT NL SE**

(72) Inventeur: **Audier, Marcel-Francis Société Civile S.P.I.D.**
**209, rue de l'Université**
**F-75007 Paris(FR)**

(74) Mandataire: **Landousy, Christian et al Société Civile S.P.I.D. 209, Rue de l'Université**
**F-75007 Paris(FR)**

(54) **Dispositif à transfert de charges (DTC), éliminateur du niveau de fond d'un signal détecté, structure de détection et procédé d'utilisation d'un tel DTC.**

(57) Dispositif à transfert de charges (DTC), éliminateur du niveau de fond d'un signal détecté, muni d'un circuit d'entrée qui comprend une source d'injection (12) et une électrode (16) qui contrôle un puits de potentiel de stockage qui peut être subdivisé en un puits d'évacuation (18) et un puits de sortie (19) séparés par le potentiel de séparation créé par une électrode de séparation (27). Ce DTC est remarquable en ce que son circuit d'entrée comprend une électrode flottante (25) reliée à l'électrode de séparation (27) afin que le potentiel de séparation soit asservi au niveau de fond, et une électrode d'isolation (28) qui isole le puits de référence (29) du puits de sortie (19), au cours des opérations de mesure, les dopages, respectivement sous l'électrode flottante sous l'électrode de séparation, étant réalisés afin que les puits de potentiel situés respectivement sous chacune de ces électrodes soient de profondeur différente l'un de l'autre.

Ce dispositif permet de réaliser des structures de détection infrarouge à l'aide de détecteurs $Cd_xHg_{1-x}Te$.

Application : détecteurs infrarouge

FIG.2D

## DISPOSITIF A TRANSFERT DE CHARGES (DTC), ELIMINATEUR DU NIVEAU DE FOND D'UN SIGNAL DETECTE, STRUCTURE DE DETECTION ET PROCEDE D'UTILISATION D'UN TEL DTC.

L'invention concerne un dispositif à transfert de charges (DTC), éliminateur du niveau de fond d'un signal détecté, muni d'un circuit d'entrée et d'un circuit de transfert réalisés dans un substrat semiconducteur, ledit signal étant détecté à l'aide du circuit d'entrée qui comprend :

-une source d'injection de charges reliée à un émetteur de charges qui délivre une quantité de charges,

-une électrode de contrôle permettant à la source d'injection d'injecter cette quantité de charges dans un puits de potentiel de stockage du DTC dont la profondeur est contrôlée par une électrode de stockage,

-le puits de stockage étant subdivisé en un puits d'évacuation et un puits de sortie séparés par le potentiel de séparation créé par une électrode de séparation qui permet de conserver dans le puits d'évacuation une quantité de charges à évacuer et de conserver dans le puits de sortie une quantité représentative du signal utile qui est lue par le circuit de transfert à l'aide d'une électrode de transfert pour être acheminée vers la sortie du DTC reliée à des organes de traitement, les charges du puits d'évacuation pouvant être évacuées à l'aide d'un transistor pour la remise à zéro.

Elle concerne également un dispositif de détection ou une structure de détection comprenant plusieurs dispositifs à transfert de charges réunis individuellement à un émetteur de charges. Ces derniers peuvent être des diodes au $Cd_xHg_{(1-x)}$-Te pour effectuer une détection infrarouge.

Une invention de ce genre est connue du document "Hybrid Infrared Focal Plane Arrays" de KUEN CHOW, J.P. RODE, D.H. SEIB, J.D. BLACKWELL, IEEE Transactions on Electron Devices vol. ED-29 n° 1 p. 3, January 1982. Ce document décrit un réseau plan focal hybride pour la détection d'un rayonnement à l'aide de détecteurs photovoltaïques et de barettes de DTC. Ce réseau opère à basse température pour détecter des rayonnements infra-rouge. Néanmoins la dynamique définie comme étant le rapport signal/niveau de fond S/D est assez faible au niveau du détecteur et il s'avère indispensable d'accroître ce rapport S/D à l'aide d'un DTC dont le ou les circuits d'entrée sont spécialement conçus pour atténuer la composante relative au niveau de fond du signal du détecteur. Pour cela le signal issu du détecteur agit sur la source d'injection du DTC pour délivrer des charges électriques qui sont introduites dans un puits de potentiel de stockage qui peut être subdivisé en deux puits, un puits d'évacuation et un puits de sortie afin d'isoler dans le puits de sortie une quantité de charges compatible avec les possibilités de transfert du DTC. Ceci est effectué à l'aide d'une électrode de séparation sur laquelle on applique extérieurement une tension électrique déterminée et fixe. Cette tension est la même pour tous les DTC constituant un dispositif de détection à plusieurs DTC. Les charges contenues dans le puits de sortie sont ensuite déversées dans le circuit de transfert du DTC à l'aide d'une électrode de transfert dont le potentiel peut être déterminé pour effectuer soit une opération d'écrémage des charges excédentaires soit un simple transfert.

Ce dispositif permet d'accroître la dynamique mais reste néanmoins insuffisant en pratique car le même potentiel est appliqué à tous les DTC constituant un dispositif de détection, en ce qui concerne les électrodes de séparation d'une part, et les électrodes de transfert d'autre part.

Or chaque source d'injection est réunie individuellement à un détecteur photovoltaïque. Il est bien évident que le niveau de fond vu par chaque DTC sera très différent à cause de l'addition de toutes les dispersions liées à la chaîne formée par le détecteur photovoltaïque, la source d'injec tion du DTC, les dimensions des électrodes, le dopage du semiconducteur dans le puits de potentiel, les tensions de seuil.

Ces dispersions peuvent atteindre 30% à 50% de la capacité de stockage maximale de la zone de transfert du DTC.

Chaque détecteur de rayonnement analyse un point d'une scène et le signal injecté puis traité par le DTC est ensuite utilisé pour restituer une image. Ces dispersions erratiques propres à chaque voie produisent une image finale très dégradée.

De même cet art antérieur en effectuant cette partition des charges et/ou associée à un écrémage des charges, ne permet pas réellement de supprimer l'influence du niveau de fond.

Le but de l'invention est donc de s'affranchir de l'action néfaste de ce cumul des dispersions propres à chaque détecteur d'accroître la qualité d'image et de supprimer le niveau de fond.

Pour cela l'invention telle que définie dans le préambule est remarquable en ce que le circuit d'entrée du DTC comprend :

-une électrode flottante reliée à l'électrode de séparation afin que le potentiel de séparation soit asservi au niveau de fond, ce potentiel étant déterminé au cours d'une opération de calibrage à l'aide d'un émetteur de charges de référence qui charge à partir du puits de stockage le puits de référence situé sous l'électrode flottante, les dopages, respectivement sous l'électrode flottante et sous l'électrode de séparation, étant réalisés afin que les puits de potentiel situés respectivement sous chacune de ces électrodes soient de profondeur différente l'un de l'autre,

-et une électrode d'isolation qui isole, au cours des opérations de mesure, le puits de référence du puits de sortie, celui-ci étant préalablement déchargé, le signal utile étant lu par l'intermédiaire du puits de référence, l'électrode flottante étant chargée à l'aide d'un transistor réuni à un potentiel de référence.

L'invention est également remarquable en ce que le substrat semiconducteur est un substrat semiconducteur à canal N et en ce que le puits de potentiel créé sous l'électrode flottante est plus profond que celui créé sous l'électrode de séparation, ceci étant obtenu en surdopant à l'aide d'éléments "donneurs" la partie du substrat semiconducteur située juste sous l'électrode flottante.

Le puits de potentiel créé plus profond sous l'électrode flottante que celui créé sous l'électrode de séparation, peut aussi être obtenu en dopant à l'aide d'éléments "accepteur" la partie du substrat semiconducteur située juste sous l'électrode de séparation.

Le puits de potentiel créé plus profond sous l'électrode flottante que celui créé sous l'électrode de séparation, peut aussi être obtenu en surdopant à l'aide d'éléments "donneurs" la partie du substrat semiconducteur située juste sous l'électrode flottante, l'électrode d'isolation et l'électrode de stockage à l'exclusion de la partie située sous l'électrode de séparation.

Le puits de potentiel créé plus profond sous l'électrode flottante que celui créé sous l'électrode de séparation, peut aussi être obtenu en surdopant à l'aide d'éléments "donneurs" la partie du substrat semiconducteur située juste sous l'électrode flottante, l'électrode d'isolation et l'électrode de stockage, et en dopant à l'aide d'éléments accepteurs la partie du substrat semiconducteur située juste sous l'électrode de séparation.

Ce dispositif à transfert de charges peut constituer un dispositif de détection mono ou bidimensionnel.

L'invention est également remarquable en ce que le procédé d'utilisation d'un tel DTC est caractérisé en ce qu'au cours d'une séquence d'opérations :

-premièrement, un calibrage du puits d'évacuation est effectué, à partir d'un rayonnement de référence,

-en chargeant, pendant une durée déterminée, à partir du puits de stockage, un puits de référence situé sous une électrode flottante afin de modifier son potentiel électrique et d'asservir le potentiel de l'électrode de séparation à laquelle elle est connectée, afin d'isoler le puits d'évacuation du puits de sortie par un potentiel de séparation calibré, les dopages, respectivement sous l'électrode flottante et sous l'électrode de séparation, étant réalisés afin que les puits de potentiel situés respectivement sous chacune de ces électrodes soient de profondeur différente l'un de l'autre,

-à l'aide d'une électrode d'isolation, le puits de sortie est isolé du puits de référence, qui est conservé chargé,

- le puits d'évacuation et le puits de sortie sont vidés de leurs charges,

-deuxièmement, la mesure sur la scène à analyser est effectuée, en introduisant les charges créées par l'émetteur de charges dans la source d'injection qui remplit d'abord le puits d'évacuation puis le puits de sortie, la quantité de charges du puits de sortie étant transférée au circuit de transfert du DTC pour être acheminée vers des organes de traitement.

La correction automatique de niveau de fond, selon l'invention, utilise la relation de proportionnalité existant entre le potentiel d'une électrode flottante et la quantité de charges électriques accumulées sous cette électrode. Au cours d'une opération de calibrage, on soumet tous les détecteurs de rayonnement à un flux de calibrage correspondant au niveau de fond à supprimer. Chaque puits de potentiel de stockage reçoit de chaque détecteur à travers chaque source d'injection une quantité de charges proportionnelle au niveau de fond reçu. Le potentiel de l'électrode flottante se détermine en conséquence et impose ainsi son potentiel à l'électrode de séparation. Celle-ci dissocie le puits d'évacuation du puits de sortie en modifiant le potentiel de séparation. Pour accroître le rapport S/D final, l'opération précédente est répétée, après avoir évacué à chaque fois les charges stockées dans le puits d'évacuation. On arrive ainsi à éliminer la quasi-totalité du niveau de fond après quelques cycles de fonctionnement. Le puits de référence et le potentiel de séparation sont alors conservés en l'état pour chaque DTC, le puits de sortie est isolé du puits de référence par l'électrode d'isolation, le puits d'évacuation et le puits de sortie sont remis à zéro, et le dispositif de détection est prêt à opérer les mesures de signal proprement dites. Chaque puits d'évacuation se recharge de la quantité de charges pour laquelle il a été dimensionné, et les charges en excès sont déversées dans le puits de sortie. A l'issue de cette étape les charges de chaque puits de sortie sont transférées dans le circuit de transfert de chaque DTC à l'aide des électrodes de transfert. Les sorties des DTC sont réunies à des organes de traitement qui délivrent des signaux pour l'image finale.

Préférentiellement l'invention concerne un dispositif de détection comportant n DTC chacun traitant un élément-d'image. Ces éléments d'image peuvent être répartis sur des portions linéaire ou bidimensionnelle de l'image. Les émetteurs de charges peuvent former avec le dispositif de détection une structure de détection hybride ou monolithique. Une structure hybride est par exemple constituée de DTC en silicium et des émetteurs de charges formés de diodes au $Cd_x Hg_{1-x}Te$ ou à l'InSb. L'invention concerne également un DTC unique muni du circuit d'entrée décrit.

L'invention sera mieux comprise à l'aide des figures suivantes, données à titre d'exemple non limitatifs, qui représentent :

figure 1 : un schéma du principe de fonctionnement du circuit d'entrée d'un DTC selon l'art antérieur.

figures 2A à 2D : un schéma de principe de fonctionnement du circuit d'entrée d'un DTC selon l'invention,

figures 3A et 3B : deux autres schémas de principe pour réaliser la dissymétrie de potentiel selon l'invention,

figure 4 : une représentation schématique de la topoligie du circuit d'entrée d'un DTC selon l'invention.

figure 5 : une représentation schématique de la topologie d'un dispositif de détection pour l'analyse bidimensionnelle des puits d'images.

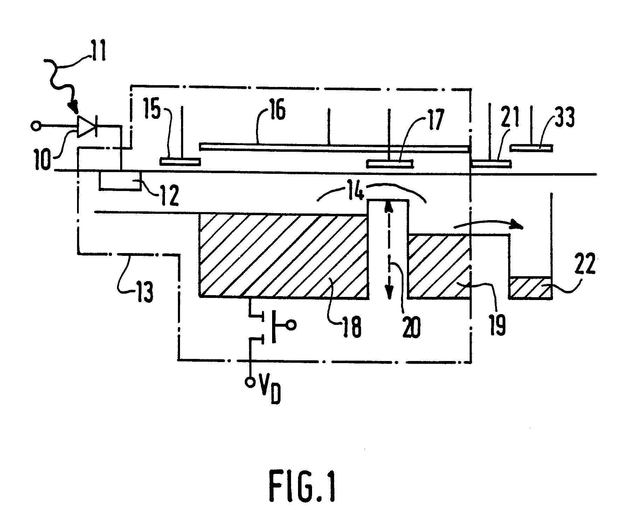

Sur la figure 1 les dimensions des différents éléments ne sont pas représentées à l'échelle. L'émetteur de charges 10 reçoit un rayonnement 11 en provenance d'une scène à visualiser. Cet émetteur 10 transmet, à l'aide de la source d'injection 12 du circuit d'entrée 13, une quantité de charges au puits de stockage 14 sous le contrôle de l'électrode de contrôle 15. Le puits de stockage 14 est déterminé en étendue par les dimensions de l'électrode de stockage 16 et en profondeur par le potentiel électrique appliqué à l'électrode de stockage. Sous celle-ci se trouve une électrode de séparation 17 qui permet de réduire le gain en divisant le puits de stockage 14 en un puits d'évacuation 18 et un puits de sortie 19 en modifiant la hauteur du potentiel de séparation 20.

Pour effectuer la mesure on applique sur l'électrode de séparation 17 un potentiel déterminé qui isole le puits de sortie 19 du puits d'évacuation 18. Les étendues de ces deux puits ainsi que leur profondeur et la hauteur du potentiel de séparation 20 sont déterminés pour chaque application afin d'accroître le rapport S/D. Lorsque le puits de sortie 19 a été isolé, les charges qu'il contient sont déversées dans le puits de transfert 22 du circuit de transfert du DTC à l'aide de l'électrode de transfert 21 et acheminées vers la sortie à l'aide des électrodes habituelles dont l'une 33 est représentée. Le potentiel de l'électrode de transfert 21 est déterminé afin de réaliser une atténuation du niveau de fond. La figure 1 représente la situation des charges dans le puits de potentiel au cours du déversement.

Les figures 2A à 2D représentent le DTC selon l'invention à différentes étapes d'utilisation du dispositif. La figure 2A le représente dans un état initial où les puits de potentiel sont dépourvus de charges.

Le circuit d'entrée 23 du DTC comprend la source d'injection 12, l'électrode de contrôle 15, l'électrode de stockage 16. Celle-ci détermine, par un potentiel appliqué, le puits de stockage 24 qui sur la figure 2A s'étend sous l'électrode flottante 25 sur laquelle est appliquée une tension de référence Vref à travers un transistor T1 muni d'une grille G1. Sous l'électrode de stockage 16 est placée l'électrode de séparation 27 reliée électriquement à l'électrode flottante 25. Le puits de potentiel 29 sous l'électrode flottante est plus profond que le puits de potentiel sous les électrodes 16 et 27 grâce à un potentiel interne obtenu, par exemple pour un dispositif à canal N en surdopant, par exemple par implantation ionique, à l'aide d'éléments donneurs, la partie du substrat semiconducteur située juste sous l'électrode flottante.

La dissymétrie des puits de potentiel peut aussi être obtenue en dopant à l'aide d'éléments "accepteur" la partie du substrat semiconducteur située juste sous l'électrode de séparation.

Elle peut aussi être obtenue en surdopant à l'aide d'éléments "donneurs" la partie du substrat semiconducteur située juste sous l'électrode flottante, l'électrode d'isolation et l'électrode de stockage à l'exclusion de la partie située sous l'électrode de séparation.

Elle peut aussi être obtenue en surdopant à l'aide d'éléments "donneurs" la partie du substrat semiconducteur située juste sous l'électrode flottante, l'électrode d'isolation et l'électrode de stockage, et en dopant à l'aide d'éléments accepteurs la partie du substrat semiconducteur située juste sous l'électrode de séparation.

Une électrode d'isolation 28 permet d'isoler le puits de sortie 19 du puits de référence 29 situé sous l'électrode flottante. Lorsqu'ils sont isolés le puits d'évacuation 18 et le puits de sortie 19 peuvent être vidés de leurs charges individuellement à l'aide des transistors T2 et T3 dont les drains sont reliés à un potentiel VD. Le transistor T3 peut être omis, auquel cas le vidage du puits de sortie s'effectue dans le circuit de transfert à l'aide de l'électrode de transfert. L'émetteur de charges 10, qui reçoit le rayonnement 11, est relié à la source d'injection 12 du DTC. L'électrode de stockage 16 peut se diviser en deux électrodes, l'une pour le puits d'évacuation l'autre pour le puits de sortie, afin de commander indépendamment la profondeur du puits de sortie.

Le mode de fonctionnement du DTC est le suivant. Les électrodes de stockage 16 et d'isolation 28 sont portées à un potentiel haut pour créer le puits d'évacuation 18 et le puits de sortie 19 qui s'étend sous l'électrode d'isolation. La grille G2 est portée à un potentiel haut pour rendre T2 conducteur afin de vider le puits 18.

A un instant to la grille G1 de T1 est portée à un potentiel haut pour rendre T1 conducteur de sorte que la grille flottante 25 est préchargée à un potentiel Vref-Vth identique aux potentiels appliqués sur les grilles 16 et 28. Vth est la tension de seuil du transistor T1. Lorsque la précharge de l'électrode flottante 25 est achevée, la grille G1 est remise à un potentiel bas (T1 bloqué) ce qui met l'électrode flottante 25 dans un état flottant. A cet instant les potentiels des électrodes 16, 27, 28 et 25 forment un vaste puits de potentiel vide de charges électriques. C'est l'état représenté par la figure 2A.

Après un temps t1, le transistor "T2" est replacé dans un état bloqué, les charges transférées de l'émetteur 10 sont alors stockées graduellement dans le puits de stockage, se répartissant uniformément sous les électrodes 16, 27, 28 et 25. Cette accumulation de charges entraîne une diminution du potentiel de l'électrode flottante donc de l'électrode de séparation 27 qui lui est reliée.

Après un temps t2, le transistor "T2" est à nouveau remis dans un état conducteur permettant ainsi l'évacuation de la totalité des charges accumulées dans le seul puits d'évacuation 18, dont le volume, dimensionné par le potentiel de l'électrode 27, est directement proportionnel à la quantité de charges fournie par le détecteur et injectée dans le semiconducteur du circuit d'entrée.

Après un temps t3, le transistor "T2" est replacé dans un état bloqué. Les charges continuement transférées de l'émetteur 10 sont dans un premier temps accumulées dans le seul puits d'évacuation, la barrière de potentiel créée par l'électrode 27 établie par les charges accumulées lors du cycle précédent ne se modifiant pas. Puis le puits d'évacuation étant rempli, les charges délivrées par l'émetteur se répartissent à nouveau sous l'ensemble des électrodes, entraînant une nouvelle diminution du potentiel de l'électrode flottante et donc de l'électrode de séparation 27.

Les cycles de remise à zéro du puits d'évacuation et d'accumulation des charges délivrées par le détecteur sont ainsi renouvelées le nombre de fois nécessaire pour dimensionner avec la précision souhaitée le puits d'évacuation.

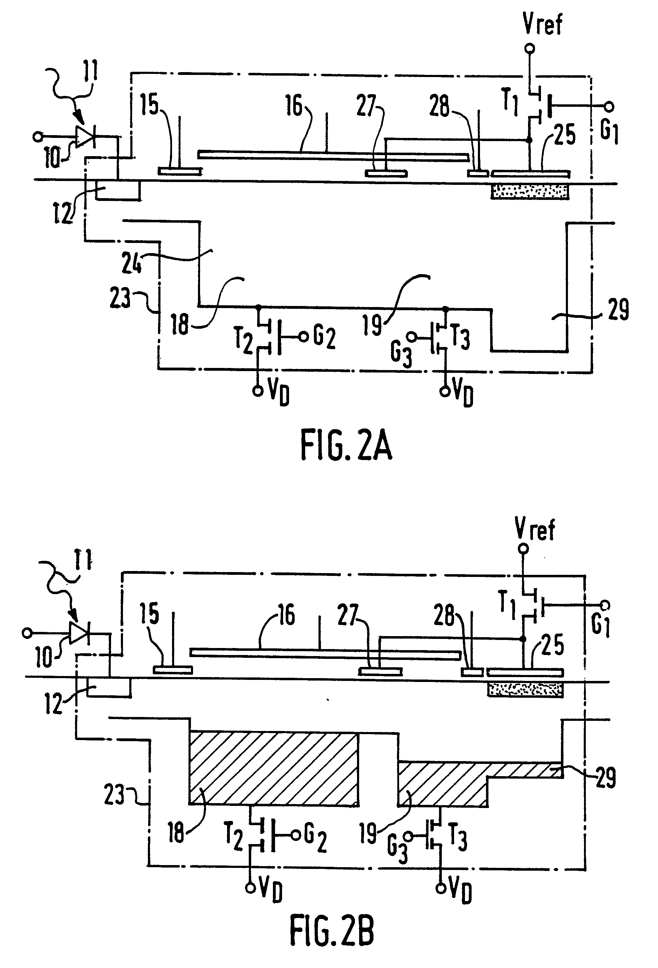

Le circuit d'entrée du DTC est alors dans l'état représenté par la figure 2B.

Ce mode itératif de détermination de la dimension du puits d'évacuation s'explique par l'importance que peut présenter le niveau de fond total donc le nombre de charges qui en découlent. Le temps total, qui sera ultérieurement nécessaire pour analyser un point-image, est ainsi décomposé en un certain nombre de tranches élémentaires de temps qui dépend de la somme totale de charges dues au niveau de fond ainsi que de la surface donnée aux électrodes définissant le puits de stockage. De cette manière, on obtient une grande précision dans la détermination du potentiel de séparation situé sous l'électrode de séparation.

Une autre possibilité de dimensionnement du puits d'évacuation consiste à utiliser une période de blocage du transistor de remise à zéro du puits, égale à la période d'analyse d'un point-image, multipliée par le rapport entre les surfaces des électrodes 16, 28, 25 et la surface dela portion de l'électrode 16 déterminant la surface du puits d'évacuation 18. Dans ce cas, en une seule opération, une charge représentative du niveau de fond sera accumulée sous l'électrode flottante 25 déterminant ainsi le potentiel de séparation situé sous l'électrode de séparation 27 ce qui dimensionne le puits d'évacuation 18.

Le puits d'évacuation étant dimensionné, le circuit d'entrée est prêt pour l'analyse de la scène. La fréquence de remise à zéro du puits d'évacuation est maintenue dans le cycle de mesure. L'électrode d'isolation 28 est remise à un potentiel bas, afin d'isoler le puits de référence (dans lequel est conservé une charge représentative du courant de fond délivré par chaque DTC-émetteur de charges) du puits de sortie dans lequel sera accumulée le signal détecté excédant le niveau de fond. Les puits de référence et signal étant isolés, le puits de sortie est remis à zéro par l'intermédiaire du transistor "T3" de manière synchrone avec la remise à zéro du puits d'évacuation ou par evacuation des charges dans le circuit de transfert.

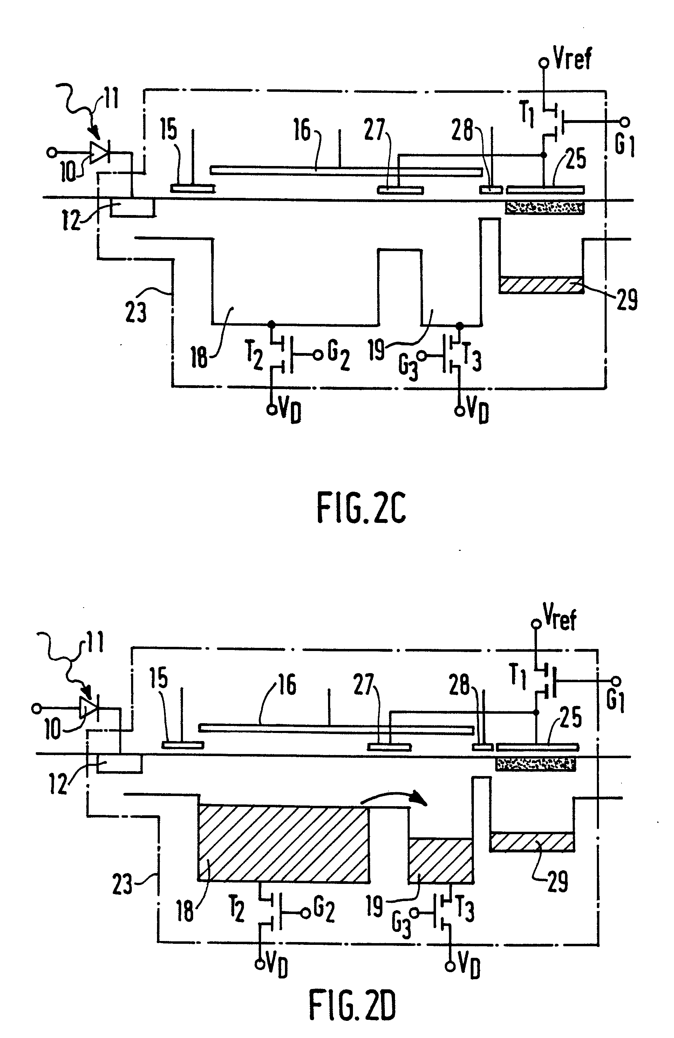

En début de séquence d'analyse d'image chaque émetteur se trouve couplé à un circuit d'entrée dont le puits d'évacuation est dimensionné d'après les caractéristiques électriques propres à chaque émetteur et à chaque source d'injection. On obtient alors l'état représenté par la figure 2C avec le puits d'évacuation et le puits de sortie vides de charges et le puits de référence chargé.

Au cours d'une période d'intégration T du signal lié à la scène, le puits d'évacuation est remis à zéro périodiquement par des périodes T/N (N entier) de telle sorte que la totalité du niveau de fond soit soustraite. Durant cette période d'intégration T, seules les charges issues de la par tie "signal", superposée au niveau de fond se déversent et sont accumulées dans le puits de sortie. On obtient alors l'état représenté par la figure 2D.

Les charges contenues dans le puits de sortie sont extraites à l'aide d'une électrode de transfert et acheminées vers le circuit de transfert du DTC pour être transférées vers la sortie du DTC puis traitées par des organes de traitement afin de restituer une image de la scène analysée.

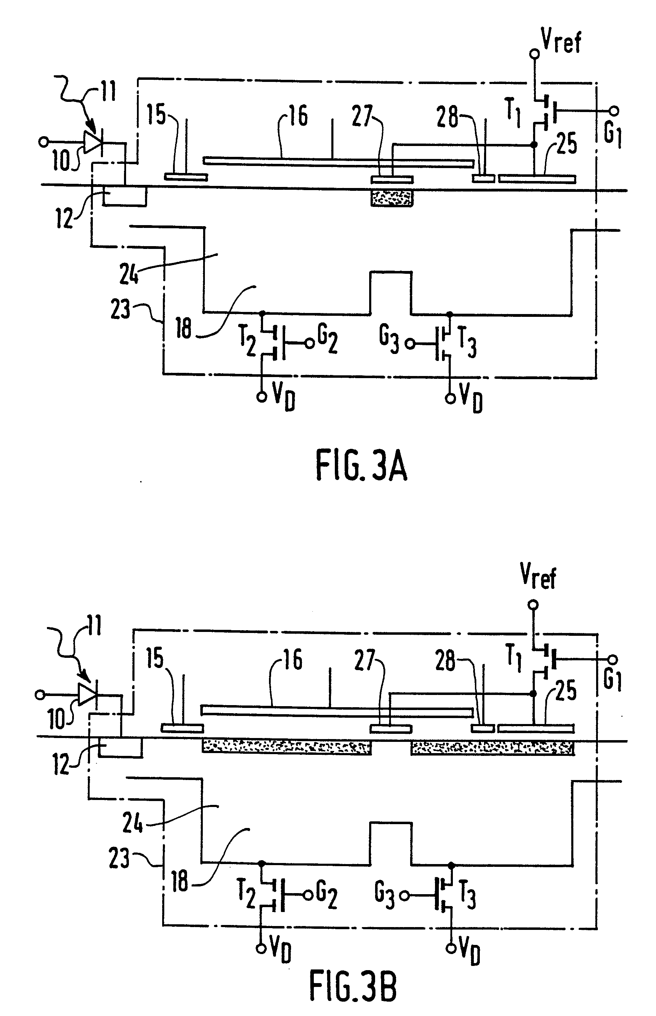

Les figures 3A et 3B représentent une autre façon de créer la dissymétrie entre les puits de potentiel situés sous respectivement l'électrode flottante 25 et l'électrode de séparation 27.

Ainsi sur la figure 3A, dans par exemple un dispositif à canal N, il est possible d'implanter des ions "accepteur" sous l'électrode de séparation 27, afin d'y fixer des charges négatives pour élever le niveau de bande plate.

Sur la figure 3B un résultat semblable est obtenu en effectuant une implantation d'ions "donneur" sous les électrodes 16, 28 et 25, à l'exclusion de l'électrode de séparation 27.

Il est possible de combiner entre elles les réalisations du dopage telles que décrites sur les figures 3A et 3B.

Bien évidemment avec un substrat d'un autre type de dopage les types d'implantation sont à modifier pour obtenir les dissymétries de puits de potentiel décrites.

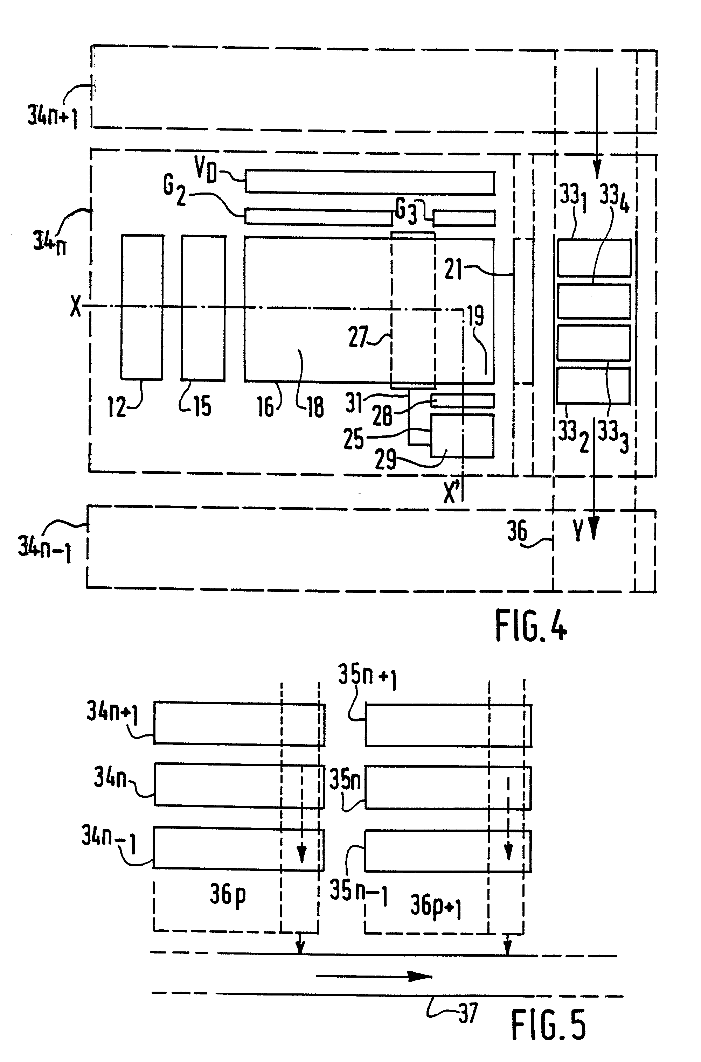

La figure 4 représente schématiquement un exemple de réalisation topologique du circuit. Les figures 2A à 2D représentent le schéma du circuit obtenu en effectuant une coupe XX' sur la figure 4. Les éléments y sont représentés avec les mêmes repères. La source d'injection 12 charge le puits d'évacuation 18 et le puits de sortie 19 à l'aide de l'électrode de contrôle 15. A l'aide de l'électrode de transfert 21 le puits de sortie 19 peut être transféré vers les puits de transfert situés par exemple sous les quatre électro des $33_1$ à $33_4$ d'un dispositif à quatre phases, qui opèrent le transfert habituel d'un DTC dans la direction Y.

L'électrode d'isolation 28 et l'électrode flottante 25 sont placées à l'écart du trajet de transfert du puits de sortie vers les puits de transfert. Une connexion électrique 31 relie l'électrode de séparation 27 et l'électrode flottante 29.

Le dispositif à transfert de charges 34n, éliminateur de niveau de fond, constitue un élément de base qui peut être reproduit n fois, tel que les dispositifs $34_{n-1}$, $34_{n+1}$, pour former un dispositif de détection permettant d'analyser plusieurs points d'image. Toutes les électrodes de transfert 21 et tous les puits de transfert sont alors réunis entre eux d'une manière continue pour former le circuit de transfert 36 du dispositif de détection afin d'effectuer l'évacuation des charges vers sa sortie. Ces dispositifs de détection $34_{n-1}$, $34_n$, $34_{n+1}$ peuvent eux aussi être reproduits à l'identique p fois pour former une disposition bidimensionnelle ($34_{n-1}$, $35_{n-1}$,...), $34_n$, $35_n$,...), ($34_{n+1}$, $35_{n+1}$,...), qui possède son propre circuit de transfert 37 réuni à tous les circuits de transfert $36_p$, $36_{p+1}$ des dispositifs de détection comme cela est indiqué sur la figure 5.

## Revendications

1. Dispositif à transfert de charges (DTC), éliminateur du niveau de fond d'un signal détecté, muni d'un circuit d'entrée et d'un circuit de transfert réalisés dans un substrat semiconducteur, ledit signal étant détecté à l'aide du circuit d'entrée qui comprend :
-une source d'injection de charges reliée à un émetteur de charges qui délivre une quantité de charges,
-une électrode de contrôle permettant à la source d'injection d'injecter cette quantité de charges dans un puits de potentiel de stockage du DTC dont la profondeur est contrôlée par une électrode de stockage,
-le puits de stockage étant subdivisé en un puits d'évacuation et un puits de sortie séparés par le potentiel de séparation créé par une électrode de séparation qui permet de conserver dans le puits d'évacuation une quantité de charges à évacuer et de conserver dans le puits de sortie une quantité représentative du signal utile qui est lue par le circuit de transfert à l'aide d'une électrode de transfert pour être acheminée vers la sortie du DTC reliée à des organes de traitement, les charges du puits d'évacuation pouvant être évacuées à l'aide d'un transistor pour la remise à zéro, caractérisé en ce que le circuit d'entrée du DTC comprend :
-une électrode flottante reliée à l'électrode de séparation afin que le potentiel de séparation soit asservi au niveau de fond, ce potentiel étant déterminé au cours d'une opération de calibrage à l'aide d'un émetteur de charges de référence qui charge à partir du puits de stockage le puits de référence situé sous l'électrode flottante, les dopages, respectivement sous l'électrode flottante et sous l'électrode de séparation, étant réalisés afin que les puits de potentiel situés respectivement sous chacune de ces électrodes soient de profondeur différente l'un de l'autre,
-et une électrode d'isolation qui isole, au cours des opérations de mesure, le puits de référence du puits de sortie, celui-ci étant préalablement déchargé, le signal utile étant lu par l'intermédiaire du puits de référence, l'électrode flottante étant chargée à l'aide d'un transistor réuni à un potentiel de référence.

2. Dispositif à transfert de charges selon la revendication 1, caractérisé en ce que le substrat semiconducteur est un substrat semiconducteur à canal N et en ce que le puits de potentiel créé sous l'électrode flottante est plus profond que celui créé sous l'électrode de séparation, ceci étant obtenu en surdopant à l'aide d'éléments "donneurs" la partie du substrat semiconducteur située juste sous l'électrode flottante.

3. Dispositif à transfert de charges selon la revendication 1, caractérisé en ce que le substrat semiconducteur est un substrat semiconducteur à canal N et en ce que le puits de potentiel créé sous l'électrode flottante est plus profond que celui créé sous l'électrode de séparation, ceci étant obtenu en dopant à l'aide d'éléments "accepteur" la partie du substrat semiconducteur située juste sous l'électrode de séparation.

4. Dispositif à transfert de charges selon la revendication 1, caractérisé en ce que le substrat semiconducteur est un substrat semiconducteur à canal N et en ce que le puits de potentiel créé sous l'électrode flottante est plus profond que celui créé sous l'électrode de séparation, ceci étant obtenu en surdopant à l'aide d'éléments "donneurs" la partie du substrat semiconducteur située juste sous l'électrode flottante, l'électrode d'isolation et l'électrode de stockage à l'exclusion de la partie située sous l'électrode de séparation.

5. Dispositif à transfert de charges selon la revendication 1, caractérisé en ce que le substrat semiconducteur est un substrat semiconducteur à canal N et en ce que le puits de potentiel créé sous l'électrode flottante est plus profond que celui créé sous l'électrode de séparation, ceci étant obtenu en surdopant à l'aide d'éléments "donneurs" la partie du substrat semiconducteur située juste sous l'électrode flottante, l'électrode d'isolation et l'électrode de stockage, et en dopant à l'aide d'éléments accepteurs la partie du substrat semiconducteur située juste sous l'électrode de séparation.

6. Dispositif à transfert de charges selon une des revendications 1 à 5, caractérisé en ce que le puits de sortie est déchargé à l'aide d'un transistor.

7. Dispositif à transfert de charges selon une des revendications 1 à 5, caractérisé en ce que le puits de sortie est déchargé dans le circuit de transfert à l'aide de l'électrode de transfert.

8. Dispositif de détection caractérisé en ce qu'il comprend n dispositifs à transfert de charges (DTC) selon une des revendications 1 à 7, chaque source d'injection de chaque DTC étant réunie individuellement à un émetteur de charges.

9. Dispositif de détection selon la revendication 8, caractérisé en ce que les n dispositifs à transfert de charges sont répétés p fois afin de permettre l'analyse bidimensionnelle des points d'images.

10. Structure de détection caractérisée en ce qu'elle comprend un dispositif de détection selon une des revendications 8 ou 9 et les émetteurs de charges associés.

11. Structure de détection selon la revendication 10, caractérisée en ce que les émetteurs de charges sont constituées de diodes sensibles au rayonnement infrarouge.

12. Structure de détection selon la revendication 11, caractérisée en ce que les diodes sont des diodes au $Cd_xHg_{1-x}Te$ ou à l'InSb.

13. Procédé mettant en oeuvre un dispositif à transfert de charges (DTC), éliminateur du niveau de fond d'un signal détecté, muni d'un circuit d'entrée et d'un circuit de transfert, ledit signal étant détecté à l'aide du circuit d'entrée qui comprend :
-une source d'injection de charges reliée à un émetteur de charges qui délivre une quantité de charges,
-une électrode de contrôle permettant à la source d'injection d'injecter cette quantité de charges dans un puits de potentiel de stockage du DTC dont la profondeur est contrôlée par une électrode de stockage,
-le puits de stockage étant subdivisé en un puits-niveau defond et un puits de sortie séparés par le potentiel de séparation créé par une électrode de séparation qui permet de conserver dans le puits d'évacuation une quantité de charges représentative du niveau de fond et de déverser dans le puits de sortie la quantité excédentaire représentative du signal utile, celle-ci étant transmise au circuit de transfert à l'aide d'une électrode de transfert pour être acheminée vers la sortie du DTC reliée à des organes de traitement, les charges du puits d'évacuation pouvant être évacuées à l'aide d'un transistor pour la remise à zéro,
caractérisé en ce qu'au cours d'une séquence d'opérations :
-premièrement, un calibrage du puits d'évacuation est effectué, à partir d'un rayonnement de référence
-en chargeant, pendant une durée déterminée, à partir du puits de stockage, un puits de référence situé sous une électrode flottante afin de modifier son potentiel électrique et d'asservir le potentiel de l'électrode de séparation à laquelle elle est connectée, afin d'isoler le puits d'évacuation du puits de sortie par un potentiel de séparation calibré, les dopages, respectivement sous l'électrode flottante et sous l'électrode de séparation, étant réalisés afin que les puits de potentiel situés respectivement sous chacune de ces électrodes soient de profondeur différente l'un de l'autre,

-à l'aide d'une électrode d'isolation, le puits de sortie est isolé du puits de référence, qui est conservé chargé,

-le puits d'évacuation et le puits de sortie sont vidés de leurs charges,

-deuxièmement, la mesure sur la scène à analyser est effectuée en introduisant les charges créées par l'émetteur de charges dans la source d'injection qui remplit d'abord le puits d'évacuation puis le puits de sortie, la quantité de charges du puits de sortie étant transférée au circuit de transfert du DTC pour être acheminée vers des organes de traitement.

FIG.1

FIG. 2A

FIG. 2B

FIG.2C

FIG.2D

FIG. 3A

FIG.3B

FIG.4

FIG.5

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | EP-A-0 129 763 (LICENTIA PATENT-VERWALTUNGS-GmbH) * Figure 2; revendication 1 * | 1,6-11 ,13 | H 01 L 27/14 H 01 L 29/78 |
| A | EP-A-0 122 588 (LICENTIA PATENT-VERWALTUNGS-GmbH & TELEFUNKEN ELECTRONIC GmbH) | .1,6-11 ,13 | |
| A,D | IEEE TRANSACTIONS ON ELECTRON DEVICES, vol. ED-29, no. 1, janvier 1982, pages 3-13, IEEE, New York, US; K. CHOW et al.: "Hybrid infrared focal-plane arrays" * Figure 2; pages 3,4, paragraphe II "Hybrid focal-plane operation" * | 1,6-12 | |
| A | US-A-4 206 371 (P.K. WEIMER) * Figures 1,8; colonne 1, ligne 64 - colonne 2, ligne 14; colonne 5, lignes 15-29 * | 2-5 | DOMAINES TECHNIQUES RECHERCHES (Int. Cl.4)<br><br>H 01 L |

Le présent rapport de recherche a été établi pour toutes les revendications

| Lieu de la recherche | Date d'achèvement de la recherche | Examinateur |
|---|---|---|
| LA HAYE | 04-08-1987 | CARDON A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur. mais publié à la date de dépôt ou après cette date
D : cité dans la demande
L : cité pour d'autres raisons

& : membre de la même famille. document correspondant

OEB Form 1503 03 82